# EUROPEAN PATENT APPLICATION

(11) **EP 4 718 452 A2**
(43) Date of publication of application: **01.04.2026**
(21) Application number: 25200043.5
(22) Date of filing: 03.09.2025
(51) Int. Cl.: G11C 7/04, G11C 11/406

(54) **MEMORY DEVICE INCLUDING MODE REGISTER AND METHOD OF READING MODE REGISTER THEREOF**

(30) Priority: 30.09.2024 KR 20240133220
(71) Applicant: Samsung Electronics Co., Ltd., Suwon-si, Gyeonggi-do 16677 (KR)
(72) Inventor: JEONG, Jinhun, 16677 Suwon-si (KR); JUNG, Junho, 16677 Suwon-si (KR); KIM, Daeyoung, 16677 Suwon-si (KR); PARK, Ki-Seok, 16677 Suwon-si (KR); JEONG, Min-Gyo, 16677 Suwon-si (KR); HAN, Kideok, 16677 Suwon-si (KR)
(74) Representative: Marks & Clerk LLP

(57) **Abstract**

A memory device includes a memory cell array including a plurality of memory cells, a control logic circuit configured to perform a refresh operation of the memory cell array based on a refresh command received from a memory controller, an input/output circuit configured to transmit user data stored in the memory cell array to the memory controller, and a mode register configured to store mode register information data related to the memory device and output the mode register information data through the input/output circuit under controlling of the control logic circuit. The control logic circuit is configured further to perform, in response to a refresh mode register read command received from the memory controller, the refresh operation of the memory cell array and an operation of controlling the mode register to output the mode register information data during a refresh execution time of the refresh operation.

## Description

### BACKGROUND

### 1. Field

Example embodiments of the present disclosure described herein relate to a semiconductor memory device, and more particularly, relate to a memory device including a mode register and a method of reading the mode register thereof.

### 2. Description of Related Art

A semiconductor memory may be mainly classified as a volatile memory or a non-volatile memory. Read and write speeds of the volatile memory (for example, a DRAM or an SRAM) are fast, but the data stored in the volatile memory disappear when a power is turned off. In contrast, the non-volatile memory may retain data even when the power is turned off. Therefore, the non-volatile memory may be used to store contents regardless of whether power is supplied or not.

A representative example of a volatile memory device is a DRAM (Dynamic Random Access Memory). A memory cell of a volatile memory device may include a single N-type transistor, serving as a switch, and a single capacitor storing electric charges corresponding to data DATA. Binary information "1" or "0" may correspond to the presence or absence of the electric charges stored in the capacitor in the memory cell, for example, whether a terminal voltage of a cell capacitor is high or low. The memory cell may be connected to a wordline and a bitline. The bitline may be connected to a sense amplifier. The sense amplifier may sense data, stored in the memory cell, through the bitline based on a voltage applied to the wordline.

A volatile memory device may include a mode register. The mode register may store various information related to the volatile memory device (for example, temperature information and/or data strobe oscillator information). However, the information stored in the mode register is input or output through data line in which general data stored in the volatile memory device are input or output. Accordingly, when a memory controller requests the information stored in the mode register, the volatile memory device may suspend the input or output operation of general data and output the information stored in the mode register, which may deteriorate performance of the volatile memory device.

### SUMMARY

Example embodiments of the present disclosure provide a memory device outputting information stored in a mode register together with a refresh operation when receiving a refresh command including a mode register read request.

According to an aspect of the present disclosure, a memory device includes a memory cell array including a plurality of memory cells, a control logic circuit configured to perform a refresh operation of the memory cell array based on a refresh command received from a memory controller, an input/output circuit configured to transmit user data stored in the memory cell array to the memory controller, and a mode register configured to store mode register information data related to the memory device and output the mode register information data through the input/output circuit under controlling of the control logic circuit. The control logic circuit is configured further to perform, in response to a refresh mode register read command received from the memory controller, the refresh operation of the memory cell array and an operation of controlling the mode register to output the mode register information data during a refresh execution time of the refresh operation.

According to an aspect of the present disclosure, a memory system includes a memory controller configured to consecutively issue a refresh command at a first period and a refresh mode register read command at a second period longer than the first period, and a memory device connected to the memory controller. The memory device includes a memory cell array including a plurality of memory cells, an input/output circuit configured to transmit user data stored in the memory cell array to the memory controller, a mode register configured to store mode register information data related to the memory device and output the mode register information data through the input/output circuit according to a request of the memory controller, and a control logic circuit configured to perform a refresh operation of the memory cell array based on the refresh command, and control the mode register to output the mode register information data in response to the refresh mode register read command while performing the refresh operation in response to the refresh mode register read command.

According to an aspect of the present disclosure, a method of operating a memory device includes periodically receiving a refresh command from a memory controller, performing a refresh operation during a refresh execution time based on the refresh command, checking whether the refresh command includes a mode register read request, and outputting, in response to the mode register read request being included in the refresh command, information data stored in the mode register corresponding to the mode register read request during the refresh execution time.

At least some of the above and other features of the invention are set out in the claims.

### BRIEF DESCRIPTION OF THE FIGURES

The above and other objects and features of the present disclosure will become apparent by describing in detail embodiments thereof with reference to the accompanying drawings.
FIG. 1 is a block diagram illustrating a memory system according to an example embodiment.
FIG. 2 is a block diagram illustrating a memory device of FIG. 1.
FIG. 3 is a block diagram illustrating an operation of the memory device of FIG. 2 according to various commands transmitted from the memory controller.
FIG. 4 is a diagram illustrating an example embodiment of scheduling a refresh command and a mode register read command transmitted from the memory controller to the memory device as shown in FIG. 3.
FIG. 5 is a block diagram illustrating a memory system performing the refresh operation and the mode register read operation of FIG. 4 in a combined manner.
FIG. 6 is a diagram illustrating an example embodiment of scheduling a refresh command and a refresh mode register read command transmitted from the memory controller to the memory device as shown in FIG. 5.
FIG. 7 is a table illustrating an example embodiment of a refresh command for performing the refresh operation and the mode register read operation in a combined manner on the memory device of FIG. 5.
FIG. 8 is a timing diagram illustrating an operation of the memory device of FIG. 5 based on a refresh mode register read command.
FIG. 9 is a flowchart illustrating a method of reading the mode register of the memory device of FIG. 5.
FIG. 10 is a diagram illustrating an example embodiment of scheduling a plurality of periodic mode register read commands for the memory device of FIG. 3.
FIG. 11 is a diagram illustrating an example embodiment of scheduling a refresh command and a refresh mode register read command transmitted from the memory controller to the memory device as shown in FIG. 5.
FIG. 12 is a diagram illustrating an example embodiment of scheduling a periodic mode register read command and an aperiodic mode register read command for the memory device of FIG. 3.
FIG. 13 is a diagram illustrating an example embodiment of scheduling a refresh command and a refresh mode register read command transmitted from the memory controller to the memory device as shown in FIG. 5.
FIG. 14 is a table illustrating another example embodiment of a refresh command for performing the refresh operation and the mode register read operation in a combined manner on the memory device of FIG. 5.

### DETAILED DESCRIPTION

Below, example embodiments of the present disclosure will be described in detail and clearly to such an extent that an ordinary one in the art easily implements the inventive concepts.

The application relates to memory devices. Below, a DRAM will be used as an example for illustrating features and functions of the present disclosure. However, other features and performances may be easily understood from information disclosed herein by a person of ordinary skill in the art. The present disclosure may be implemented by other embodiments or applied thereto. Further, the detailed description may be modified or changed according to viewpoints and applications without escaping from the scope, spirit, and other objects of the present disclosure.

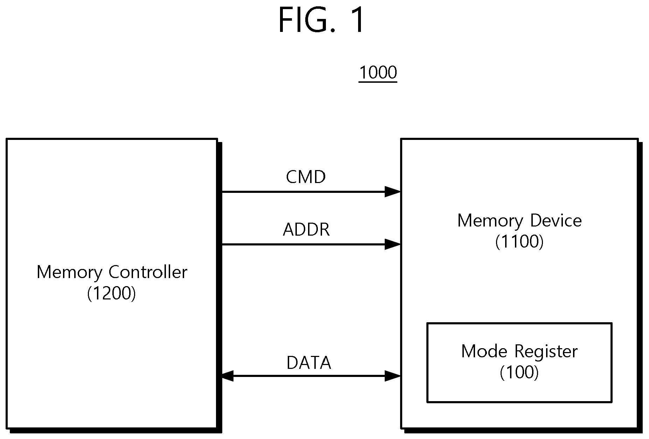

FIG. 1 is a block diagram illustrating a memory system according to an example embodiment. Referring to FIG. 1, a memory system 1000 may include a memory device 1100 and a memory controller 1200.

The memory device 1100 may output data DATA, requested to be read by the memory controller 1200, to the memory controller 1200 or may store data DATA, requested to be written by the memory controller 1200, in a memory cell of the memory device 1100. The memory device 1100 may input and output data DATA based on a command CMD and an address ADDR received from the memory controller 1200. The memory device 1100 may include memory banks.

The memory device 1100 may be a volatile memory device such as a dynamic random access memory (DRAM), a synchronous dynamic random access memory (SDRAM), a double data rate (DDR) DRAM, a DDR SDRAM, a low-power double data rate (LPDDR) SDRAM, a graphics double data rate (GDDR) SDRAM, a Rambus dynamic random access memory (RDRAM), and a static random access memory (SRAM). Alternatively, the memory device 1100 may be implemented as a nonvolatile memory device such as a resistive RAM (RRAM), a phase change memory (PRAM), a magnetoresistive memory (MRAM), a ferroelectric memory (FRAM), and a spin-transfer torque RAM (STT-RAM). In the present specification, the advantages of the present disclosure have been described with respect to a DRAM, but example embodiments are not limited thereto.

The memory banks may include a memory cell array divided in units of banks, a row decoder, a column decoder, a sense amplifier, or a write driver. The memory banks may store data DATA, requested to be written in the memory device 1100, through the write driver and may read data DATA, requested to be read, using the sense amplifier. The memory banks may further include a component for a refresh operation of storing and maintaining data in the cell array, or select circuits selecting a wordline or a bitline based on an address.

The memory controller 1200 may perform an access operation of writing data to the memory device 1100 or reading data stored in the memory device 1100. For example, the memory controller 1200 may generate a command CMD and an address ADDR for writing data to the memory device 1100 or reading data stored in the memory device 1100. The memory controller 1200 may include at least one of a control circuit controlling the memory device 1100, a system-on-chip (SoC) such as an application processor (AP), a central processing unit (CPU), a digital signal processor (DSP), and a graphics processing unit (GPU).

The memory controller 1200 may provide various signals to the memory device 1100 to control an overall operation of the memory device 1100. For example, the memory controller 1200 may control memory access operations of the memory device 1100 such as a read operation and a write operation. The memory controller 1200 may provide the command CMD and the address ADDR to the memory device 1100 to write data DATA in the memory device 1100 or to read data DATA from the memory device 1100.

The memory controller 1200 may generate various types of commands CMD to control the memory device 1100. For example, the memory controller 1200 may generate a bank request corresponding to a bank operation of changing a state of a memory bank, among memory banks, to read or write data DATA.

As an example, the bank request may include an active request for changing a state of a memory bank, among the memory banks, to an active state. The memory device 1100 may activate a row included in the memory bank, for example, a wordline, in response to the active request. The bank request may include a precharge request for changing the memory banks from an active state to a standby state after reading or writing of data DATA is completed.

The memory controller 1200 may generate an input/output (I/O) request (for example, a column address strobe (CAS) request) for the memory device 1100 to perform a read operation or a write operation of data DATA. As an example, the I/O request may include a read request for reading data DATA from activated memory banks. The I/O request may include a write request for writing data DATA in the activated memory banks.

The memory controller 1200 may generate a refresh command to control a refresh operation on the memory banks. However, the types of commands CMD described herein are merely examples, and other types of commands CMD may be present.

The memory device 1100 may include a mode register 100. For example, the mode register 100 may store various information (for example, temperature information of the memory device 1100 and/or data strobe oscillator information of a data strobe oscillator in the memory device) of the memory device 1100. The memory controller 1200 may transmit a mode register read command to the memory device 1100 to obtain the information stored in the mode register 100. When receiving the mode register read command, the memory device 1100 may output information corresponding to the mode register read command. In an embodiment, the data strobe oscillator may generate a stable oscillating signal that helps maintain timing accuracy between the memory controller 1200 and the memory device 1100. The memory controller 1200 may interact with the data strobe oscillator of the memory device 1100 to adjust timing parameters dynamically based on environmental conditions (e.g., temperature fluctuations), perform training to optimize signal alignment, or improve error margins and signal integrity for high-frequency operations. The mode register 100 may store configuration parameters for the data strobe oscillator, allowing an operation of the memory controller 1200 to be enabled or adjusted. In an embodiment, at least one temperature sensor may measure a temperature of the memory device 1100, and the measured temperature information may be stored in the mode register 100. The memory controller 1200 may read the temperature information from the mode register 100, thereby adjusting the operation of the memory controller 1200. The at least one temperature sensor may be disposed in the memory device 1100 or may be adjacent thereto.

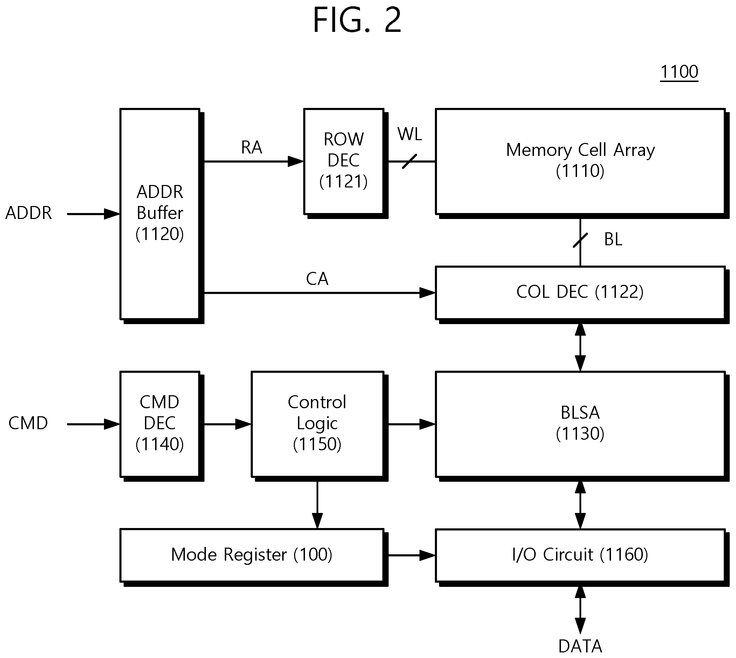

FIG. 2 is a block diagram illustrating a memory device of FIG. 1. Referring to FIG. 2, the memory device 1100 may include a memory cell array 1110, an address buffer 1120, a row decoder 1121, a column decoder 1122, a bitline sense amplifier 1130, a command decoder 1140, control logic 1150 and an input/output circuit 1160. The memory device 1100 may further include a mode register 100.

The memory cell array 1110 may include a plurality of memory cells arranged in a matrix of rows and columns. For example, the memory cell array 1110 may include a plurality of wordlines WL and a plurality of bitlines BL connected to memory cells. The plurality of wordlines WL may be connected to rows of the memory cells, and the plurality of bitlines BL may be connected to columns of the memory cells.

The address buffer 1120 may receive an address ADDR from the memory controller 1200 of FIG. 1. For example, the address ADDR may include a row address RA addressing a row of the memory cell array 1110 and a column address CA addressing a column of the memory cell array 1110. The address buffer 1120 may transmit the row address RA to the row decoder 1121 and may transmit the column address CA to the column decoder 1122.

The row decoder 1121 may select one of the plurality of wordlines WL connected to the memory cell array 1110. The row decoder 1121 may decode the row address RA, received from the address buffer 1120, to select a single wordline corresponding to the row address RA and may activate the selected wordline.

The column decoder 1122 may select a predetermined bitline from among the plurality of bitlines BL of the memory cell array 1110. The column decoder 1122 may decode the column address CA, received from the address buffer 1120, to select the predetermined bitline BL corresponding to the column address CA.

The bitline sense amplifier 1130 may be connected to the bitlines BL of the memory cell array 1110. For example, the bitline sense amplifier 1130 may sense a change in voltage of a selected bitline, among the plurality of bitlines BL, and may amplify and output the change in voltage.

The command decoder 1140 may decode a write enable signal /WE, a row address strobe signal /RAS, a column address strobe signal /CAS, and a chip select signal /CS received from the memory controller 1200 such that control signals corresponding to the command CMD are generated in the control logic 1150. The command CMD may include an active request, a read request, a write request, or a precharge request.

The control logic 1150 may control an overall operation of the bitline sense amplifier 1130 through the control signals corresponding to the command CMD. The control logic 1150 may generate control signals such that the bitline sense amplifier 1130 operates as a single-ended sense amplifier. The control logic 1150 may control an overall operation of the memory device 1100.

The input/output circuit 1160 may output data DATA to the memory controller 1200 through data pad based on a sensed and amplified voltage from the bitline sense amplifier 1130. For example, the input/output circuit 1160 may include an input buffer or an output buffer. The input buffer or the output buffer may be connected to the data pad. The input/output circuit 1160 may perform a serialization operation or a deserialization operation of data DATA.

The mode register 100 may store various information (for example, temperature information and/or data strobe oscillator information) of the memory device 1100. The command decoder 1140 may receive a mode register read command from the memory controller 1200. The command decoder 1140 may decode the mode register read command, and the control logic 1150 may control the mode register 100 to output information corresponding to the decoded mode register read command. The mode register 100 may transmit the information corresponding to the mode register read command to the input/output circuit 1160 according to controlling of the control logic 1150.

However, the information corresponding to the mode register read command is output by using a data line through which general data DATA is input or output by the input/output circuit 1160. Accordingly, when the mode register read command is received from the memory controller 1200, the memory device 1100 may temporarily suspend input or output of data DATA stored in the memory cell array 1110. After the information corresponding to the mode register read command is output, the memory device 1100 may resume the input or output of data DATA which was suspended. Accordingly, when frequency of receiving the mode register read command increases, performance of the memory device 1100 may be affected.

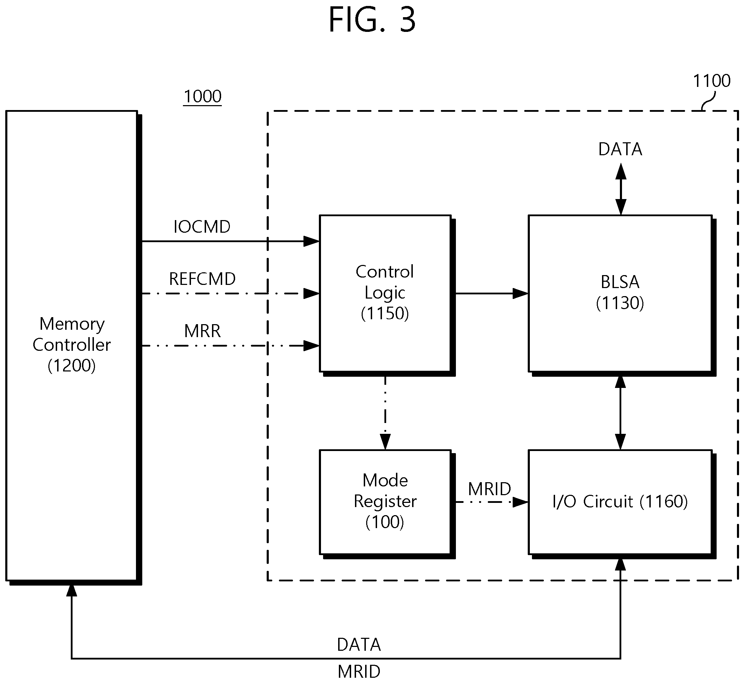

FIG. 3 is a block diagram illustrating an operation of the memory device of FIG. 2 according to various commands transmitted from the memory controller. Referring to FIG. 3, the memory controller 1200 may transmit an input/output command IOCMD, a refresh command REFCMD (i.e., a normal refresh command) and/or a mode register read command MRR to the memory device 1100. The control logic 1150 may receive a command decoded by the command decoder 1140 of FIG. 2. However, for convenience of explanation, the control logic 1150 is illustrated in FIG. 3 as receiving an input/output command IOCMD, a refresh command REFCMD and/or a mode register read command MRR from the memory controller 1200.

When receiving an input/output command IOCMD (for example, a read request or a write request), the control logic 1150 may control an overall operation of the memory device 1100 based on the input/output command IOCMD. The control logic 1150 may control the bit line sense amplifier 1130, thereby inputting or outputting user data DATA to or from the memory cell array 1110 of FIG. 2. The user data DATA may be input or output by the controlling of the input/output circuit 1160. The input/output circuit 1160 may transmit or receive the user data DATA to or from the memory controller 1200.

When receiving a refresh command REFCMD, the control logic 1150 may perform a refresh operation on memory cells included in the memory cell array 1110. For maintaining reliability of the user data DATA stored in the memory cell array 1110, the memory controller 1200 may transmit the refresh command REFCMD according to a first specified cycle (for example, 3.9 us). As the user data DATA may not be input or output from the memory cell array 1110 while performing the refresh operation, the input/output circuit 1160 may suspend operating under the control of the control logic 1150.

When receiving the mode register read command MRR, the mode register 100 may output mode register information data MRID corresponding to the mode register read command MRR under the control of the control logic 1150. The mode register information data MRID may be transmitted to the memory controller 1200 through the input/output circuit 1160. The mode register read command MRR may be periodic or aperiodic based on information included in the corresponding mode register information data MRID.

As an example, a mode register storing temperature information and/or data strobe oscillator information may be periodically requested by the memory controller 1200. The memory controller 1200 may transmit a mode register read command MRR (for example, MRR4) according to a second specified period (for example, 16 ms) to obtain temperature information of the memory device 1100. The memory controller 1200 may transmit a mode register read command MRR (for example, MRR46/47) according to a third specified period (for example, 64 ms) to obtain data strobe oscillator information of the memory device 1100. A transmission period of a mode register read command MRR may be greater than a transmission period of a refresh command REFCMD.

The mode register information data MRID is transmitted to the memory controller 1200 through the input/output circuit 1160 as like the user data DATA. Accordingly, when the memory device 1100 receives the mode register read command MRR, the input or output operation of the user data DATA is temporarily suspended. The mode register information data MRID having periodicity may more frequently suspend the input or output operation of the user data DATA, and thus the performance of the memory device 1100 may be degraded. The description of "the mode register information data MRID having periodicity" may refer to a periodic outputting of the mode register information data MRID.

A refresh operation is performed periodically, and the input/output circuit 1160 is not used while the refresh operation is performed. The refresh operation may require a process of precharging at least one memory bank, sensing data and re-inputting data, and thus may take a specified time (for example, a refresh execution time tRFC (i.e., a refresh cycle time)). For example, the refresh execution time tRFC may be time taken to complete a refresh command, which will be described below. Therefore, when a read operation of the mode register 100 is performed together during this refresh execution time tRFC, the mode register information data MRID may be transmitted to the memory controller 1200 without performance degradation of the memory device 1100.

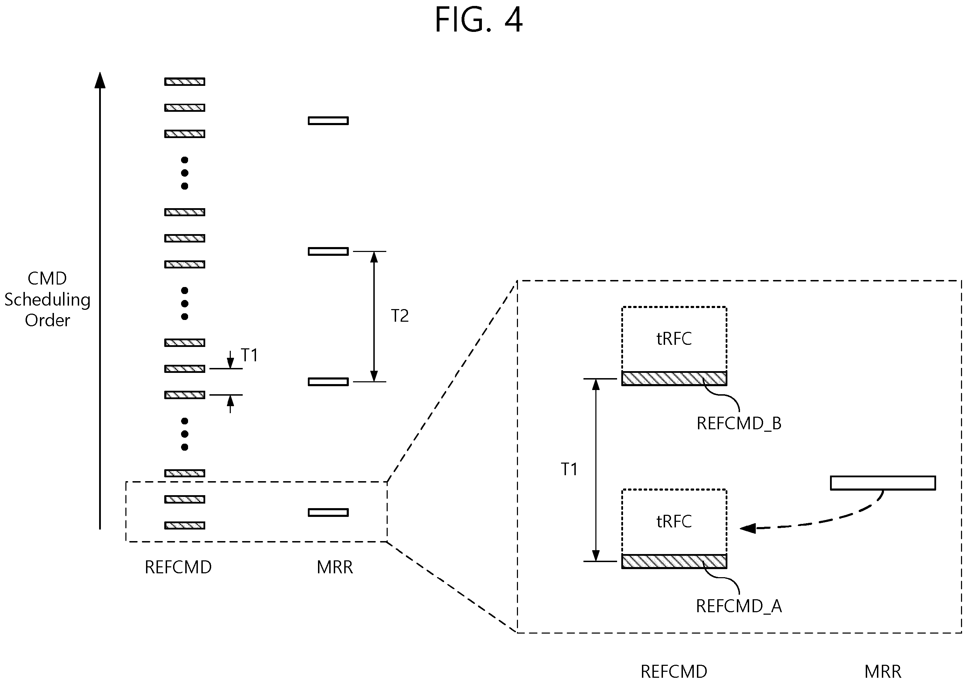

FIG. 4 is a diagram illustrating an example embodiment of scheduling a refresh command and a mode register read command transmitted from the memory controller to the memory device as shown in FIG. 3. Referring to FIGS. 3 and 4, the memory controller 1200 may transmit a refresh command REFCMD to the memory device 1100 in a first period T1 (for example, 3.9 us). For instance, the refresh command REFCMD may be transmitted periodically with a first period T1 (for example, 3.9 us). A time interval between two adjacent (e.g. successive) refresh commands REFCMD may correspond to the first period T1. The memory controller 1200 may transmit a mode register read command MRR (for example, a mode register read command for a MR4 mode register storing temperature information) having periodicity in a second period T2 (for example, 16 ms) to the memory device 1100. As an example, the second period T2 may be set to be greater than the first period T1. For example, the memory controller 1200 may consecutively transmit the mode register read command MRR to the memory device 1100 at the second period T2. A time interval between two adjacent (e.g. successive) mode register read commands MRR may correspond to the second period T2.

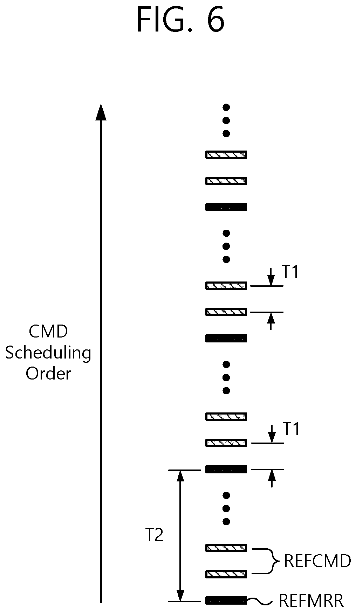

One of the mode register read commands MRR may be matched with close one of refresh commands REFCMD (e.g. a refresh command REFCMD that is closest in time to the mode register read command MRR). For example, when the memory controller 1200 may be scheduled to issue a mode register command MRR at a time between issuing two adjacent refresh commands, the memory controller 1200 may combine the mode register command MRR with a refresh command REFCMD closer thereto among the two adjacent refresh commands REFCMD. For example, a time point when the mode register command MRR is to be issued is closer to a time point when a refresh command REFCMD_A is to be issued than a time point when another refresh command REFCMD_B is to be issue. The memory controller may combine the mode register command MRR with the refresh command REFCMD _A to generate a refresh mode register read command REFMRR, which will be described with reference to FIG. 6. When the refresh command REFCMD and the mode register read command MRR are performed separately, the memory device 1100 may once suspend an input or output of the user data DATA to perform the refresh command REFCMD, and again suspend the input or output of the user data DATA to perform the mode register read command MRR.

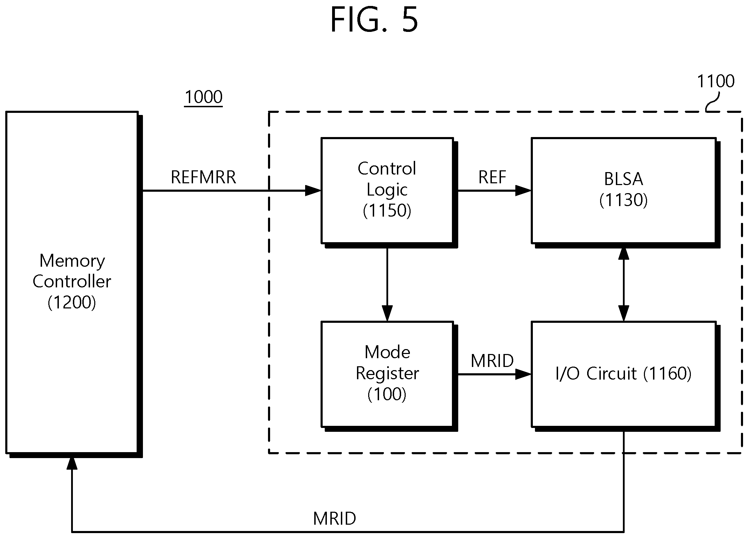

FIG. 5 is a block diagram illustrating a memory system performing the refresh operation and the mode register read operation of FIG. 4 in a combined manner. Referring to FIGS. 4 and 5, the memory controller 1200 may transmit a refresh mode register read command REFMRR for combined execution of a refresh operation and a mode register read operation to the memory device 1100.

When receiving the refresh mode register read command REFMRR, the control logic 1150 may perform a refresh operation of a memory bank corresponding to the refresh mode register read command REFMRR based on a refresh operation signal REF. The mode register 100 may output mode register information data MRID corresponding to the refresh mode register read command REFMRR under the control of the control logic 1150. The mode register information data MRID may be transmitted to the memory controller 1200 through the input/output circuit 1160.

The memory controller 1200 may perform a refresh operation and a mode register read operation simultaneously with a single refresh mode register read command REFMRR by combining one of refresh commands REFCMD and one of mode register read commands MRR close to each other (e.g. by combining a mode register read command MRR with a refresh command that is closest in time to the mode register read command MRR). The mode register read operation may be performed within a refresh execution time tRFC for performing the refresh operation. Accordingly, the memory device 1100 may not need to separately suspend input or output of user data DATA for performing the mode register read operation, and performance degradation of the memory device 1100 may be prevented.

FIG. 6 is a diagram illustrating an example embodiment of scheduling a refresh command and a refresh mode register read command transmitted from the memory controller to the memory device as shown in FIG. 5. Referring to FIGS. 3 to 6, the memory controller 1200 may transmit a refresh command REFCMD to a memory device 1100 in a first period T1 (for example, 3.9 us).

The memory controller 1200 may transmit a refresh mode register read command REFMRR (for example, a refresh command including a read request for a MR4 mode register storing temperature information) to the memory device 1100 in a second period T2 (for example, 16 ms). The second period T2 may be an integer multiple of the first period T1. The refresh command REFCMD and the refresh mode register read command REFMRR may have a time interval of the first period T1. For example, the memory controller 1200 may consecutively transmit the refresh mode register read command REFMRR at the second period T2, and, between two adjacent refresh mode register read commands REFMRR, may consecutively transmit the refresh command REFCMD at a first period T1. The refresh mode register read command REFMRR may serve as a refresh command, and thus with the refresh mode register read command REFMRR and the refresh command REFCMD, the memory controller 1200 may consecutively perform a refresh operation on the memory device 1100 at the first period T1.

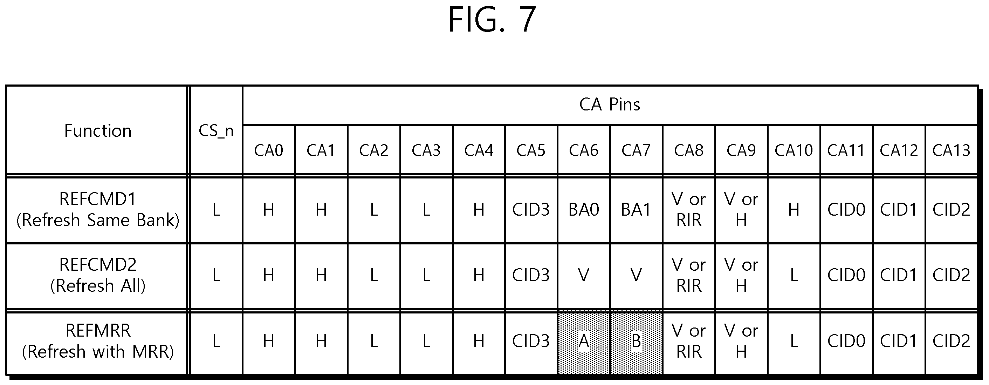

FIG. 7 is a table illustrating an example embodiment of a refresh command for performing the refresh operation and the mode register read operation in a combined manner for the memory device of FIG. 5. Referring to FIG. 7, a first refresh command REFCMD1 and a second refresh command REFCMD2 are refresh commands for a normal refresh operation (e.g. without a mode register read operation). A refresh mode register read command REFMRR is a refresh command for combined execution of a refresh operation and a mode register read operation.

The first refresh command REFCMD1 may provide bank address information to a specified column address pin (for example, CA6 and CA7), and then the memory device 1100 may perform a refresh operation for a memory bank corresponding to the bank address information in response to the first refresh command REFCMD1. The second refresh command REFCMD2 may include a refresh request for all memory banks by providing a specific voltage to the specified column address pin (for example, CA6 and CA7), and then the memory device 1100 may perform refresh operations for all memory banks in response to the second refresh command REFCMD2. For example, in FIG. 7, regarding the second refresh command REFCMD2, "V" represent the specific voltage provided to the column address pins of CA6 and CA7.

When receiving the refresh mode register read command REFMRR, the memory device 1100 may perform refresh operations for all memory banks. The refresh mode register read command REFMRR may provide location information of a mode register where a read operation (i.e., a mode register read operation) is to be performed on a specified column address pin (for example, CA6 and CA7). The mode register where the read operation is to be performed periodically may be pre-specified (for example, "00" may be a mode register storing temperature information, and/or "01" may be a mode register storing data strobe oscillator information) to be determined by information of a specified column address pin (for example, CA6 and CA7). For example, regarding the refresh mode register read command, "A" and "B" may represent address information provided through the address pins CA6 and CA7, for example in the refresh mode register read command REFMRR. The value of "A" and "B" may serve as the location information of the mode register 100. With the address pins CA6 and CA7 having "00", the memory controller 1200 may access the location of the mode register 100 storing the temperature information of the memory device 1100 and read the temperature information from the mode register 100. With the address pins CA6 and CA7 having "01", the memory controller 1200 may access the location of the mode register 100 storing the data strobe oscillator information of the memory device 1100 and read the data strobe oscillator information from the mode register 100.

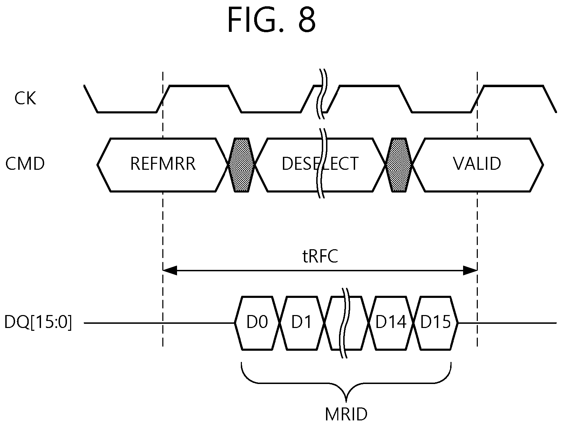

FIG. 8 is a timing diagram illustrating an operation of the memory device of FIG. 5 based on a refresh mode register read command. Referring to FIGS. 5 and 8, the memory controller 1200 may transmit a refresh mode register read command REFMRR to the memory device 1100 based on a clock signal CK.

When receiving the refresh mode register read command REFMRR, the memory device 1100 may perform refresh operations for all memory banks during the refresh execution time tRFC. The memory device 1100 may output mode register information data MRID through the data line DQ connected to the input/output circuit 1160 within the refresh execution time tRFC. Accordingly, the memory device 1100 may not need to separately suspend input or output of user data DATA for performing the mode register read operation, and performance degradation of the memory device 1100 may be prevented.

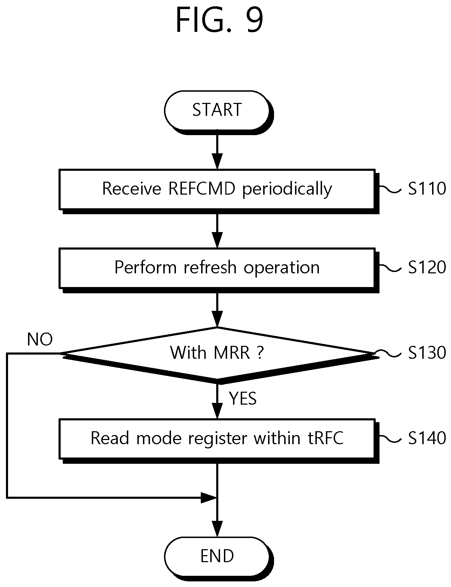

FIG. 9 is a flowchart illustrating a method of reading the mode register of the memory device of FIG. 5. Referring to FIGS. 3, 5 and 9, the memory device 1100 may periodically receive a refresh command from the memory controller 1200 and check whether a mode register read request is included in the refresh command.

In operation S110, the memory device 1100 may periodically receive a refresh command REFCMD from the memory controller 1200. For example, the refresh command REFCMD may be received in a first period T1. The refresh command REFCMD may be consecutively received at a first period T1. A time interval between two refresh commands REFCMD consecutively received may be the first period T1.

In operation S120, the memory device 1100 may perform a refresh operation based on the refresh command REFCMD. For example, the refresh operation may be performed during a refresh execution time tRFC. The execution time of each refresh command REFCMD may be the refresh execution time tRFC.

In operation S130, the memory device 1100 may check whether the refresh command REFCMD includes a mode register read request MRR. For example, the refresh command REFCMD may be one of the first refresh command REFCMD1, the second refresh command REFCMD2, and the refresh mode register read command REFMRR of FIG. 7. For example, in operation S130, a kind of a refresh command may be identified as one of the first refresh command REFCMD1, the second refresh command REFCMD2, and the refresh mode register read command REFMRR.

When the refresh command REFCMD is checked as (e.g. determined to be) one of the first refresh command REFCMD1 and the second refresh command REFCMD2, the memory device 1100 may only perform a refresh operation. When the refresh command REFCMD is checked as (e.g. determined to be) the refresh mode register read command REFMRR, the memory device 1100 may perform operation S140.

In operation S140, when the refresh command REFCMD is the refresh mode register read command REFMRR, the memory device 1100 may perform a read operation on the mode register 100 within the refresh execution time tRFC. For example, the mode register 100 may transmit mode register information data MRID corresponding to the refresh mode register read command REFMRR to the memory controller 1200 through the input/output circuit 1160 under the control of the control logic 1150.

As described above, the memory device 1100 may perform the read operation of the mode register 100 simultaneously with the refresh operation. Accordingly, the memory device 1100 may not need to separately suspend the input or output of the user data DATA for performing the mode register read operation, and performance degradation of the memory device 1100 may be prevented.

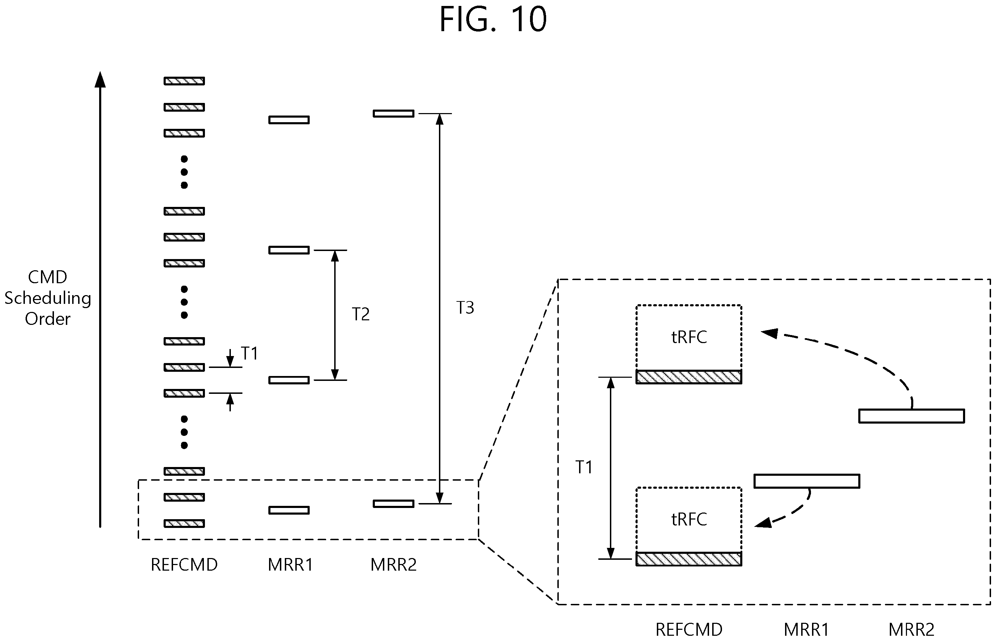

FIG. 10 is a diagram illustrating an example embodiment of scheduling a plurality of periodic mode register read commands for the memory device of FIG. 3. Referring to FIGS. 3 and 10, the memory controller 1200 may transmit a refresh command REFCMD to the memory device 1100 with a first period T1 (for example, 3.9 us).

The memory controller 1200 may transmit a first mode register read command MRR1 (for example, a read command for a MR4 mode register storing temperature information) having periodicity to the memory device 1100 with a second period T2 (for example, 16 ms). For example, the memory controller 1200 may consecutively transmit the first mode register read command MRR1 to the memory device 1100 at the second period T2. A time interval between two adjacent first mode register read commands MRR1 may be the second period T2. As an example, the second period T2 may be set greater than the first period T1.

The memory controller 1200 may transmit a second mode register read command MRR2 (for example, a read command for MR46/47 mode registers storing data strobe oscillator information) having periodicity of a third period T3 (for example, 64 ms) to the memory device 1100. For example, the memory controller 1200 may consecutively transmit the second mode register read command MRR2 to the memory device 1100 at the third period T3. A time interval between two adjacent second mode register read command MRR2 may be the third period T3. As an example, the third period T3 may be set greater than the second period T2.

One of the first mode register read commands MRR1 may be matched with one of the refresh commands REFCMD which is close to one of the first mode register read commands MRR1 (e.g. the refresh command REFCMD that is closest in time to the first mode register read command MRR1). One of the second mode register read commands MRR2 may be matched with one of the refresh commands REFCMD which is close to one of the second mode register read commands MRR2 (e.g. the refresh command REFCMD that is closest in time to the second mode register read command MRR2).

When the refresh command REFCMD, the first mode register read command MRR1 and the second mode register read command MRR2 are performed separately, the memory device 1100 may suspend input or output of user data DATA once to perform the refresh command REFCMD, and suspend the input or output of user data DATA again to perform the first mode register read command MRR1 and/or the second mode register read command MRR2.

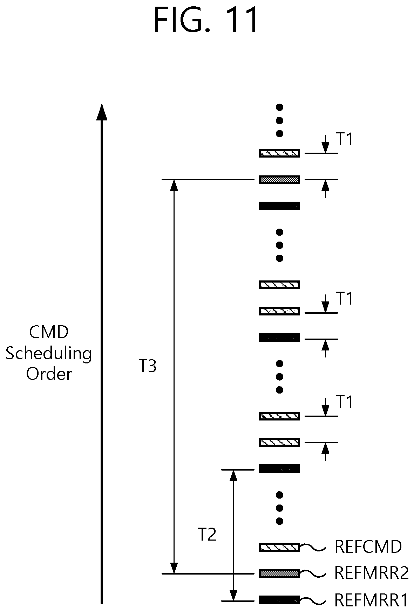

FIG. 11 is a diagram illustrating an example embodiment of scheduling a refresh command and a refresh mode register read command transmitted from the memory controller to the memory device as shown in FIG. 5. Referring to FIGS. 5, 10 and 11, the memory controller 1200 may transmit a refresh command REFCMD to the memory device 1100 in a first period T1 (for example, 3.9 us). For example, the memory controller 1200 may consecutively transmit the refresh command REFCMD to the memory device 1100 at the first period T1. A time interval between two adjacent refresh commands REFCMD may be the first period T1.

The memory controller 1200 may transmit a first refresh mode register read command REFMRR1 (for example, a refresh command including a read request for a MR4 mode register storing temperature information) to the memory device 1100 in a second period T2 (for example, 16 ms). For example, the memory controller 1200 may consecutively transmit the first refresh mode register read command REFMRR1 to the memory device 1100 at the first period T2. A time interval between two adjacent first refresh mode register read commands REFMRR1 may be the second period T2. the refresh command REFCMD and the first refresh mode register read command REFMRR1 adjacent to each other may have a time interval of the first period T1.

The memory controller 1200 may transmit a second refresh mode register read command REFMRR2 (for example, a refresh command including a read request for MR46/47 mode registers storing data strobe oscillator information) to the memory device 1100 in a third period T3 (for example, 64 ms). The refresh command REFCMD and the second refresh mode register read command REFMRR2 may have a time interval of the first period T1. With the refresh command REFCMD, the first refresh mode register read command REFMRR1, and the second refresh mode register read command REFMRR2, the memory controller 1200 may consecutively perform a refresh operation at the first period T1. The second period T2 may be an integer multiple of the first period T1. The third period T3 may be an integer multiple of the first period T1. The third period T3 may be an integer multiple of the second period T2.

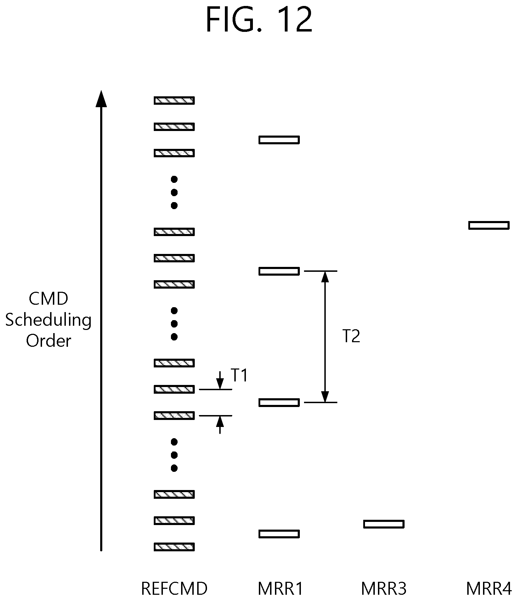

FIG. 12 is a diagram illustrating an example embodiment of scheduling a periodic mode register read command and an aperiodic mode register read command for the memory device of FIG. 3. Referring to FIGS. 3 and 12, the memory controller 1200 may transmit a refresh command REFCMD to the memory device 1100 with a first period T1 (for example, 3.9 us).

The memory controller 1200 may transmit the first mode register read command MRR1 (for example, a read command for a MR4 mode register storing temperature information) having periodicity with a second period T2 (for example, 16 ms) to the memory device 1100. For example, the memory controller 1200 may consecutively transmit the first mode register read command MRR1 to the memory device 1100 at the second period T2. A time interval between two adjacent first mode register read commands MRR1 may be the second period T2. As an example, the second period T2 may be set greater than the first period T1.

The memory controller 1200 may transmit a third mode register read command MRR3 and/or a fourth mode register read command MRR4 which do not have periodicity to the memory device 1100. For example, the memory controller 1200 may transmit the third mode register read command MRR3 and/or the fourth mode register read command MRR4 in an aperiodic manner.

One of the first mode register read commands MRR1 may be matched with one of the refresh commands REFCMD which is close (e.g. closest in time) to one of the first mode register read commands MRR1. One of the third mode register read command MRR3 and the fourth mode register read command MRR4 may also be matched with one of the refresh commands REFCMD which is close (e.g. closest in time) to one of the third mode register read command MRR3 and the fourth mode register read command MRR4.

When the refresh command REFCMD, the first mode register read command MRR1, the third mode register read command MRR3 and/or the fourth mode register read command MRR4 are each performed separately, the memory device 1100 may suspend input or output of user data DATA once to perform the refresh command REFCMD, and suspend the input or output of user data DATA again to perform the first mode register read command MRR1, the third mode register read command MRR3 and/or the fourth mode register read command MRR4.

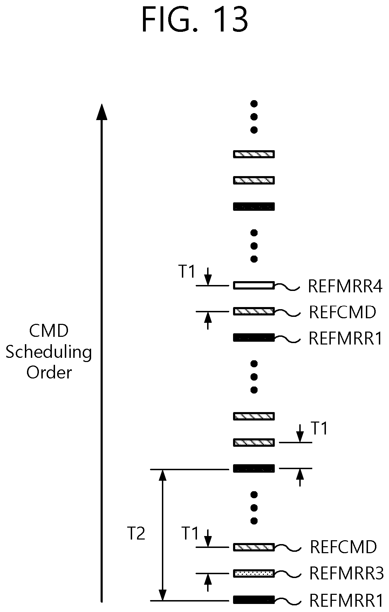

FIG. 13 is a diagram illustrating an example embodiment of scheduling a refresh command and a refresh mode register read command transmitted from the memory controller to the memory device as shown in FIG. 5. Referring to FIGS. 5, 12 and 13, the memory controller 1200 may transmit a refresh command REFCMD to the memory device 1100 in a first period T1 (for example, 3.9 us). For example, the memory controller 1200 may consecutively transmit the refresh command REFCMD to the memory device 1100 at the first period T1. A time interval between two adjacent refresh commands REFCMD may be the first period T1.

The memory controller 1200 may transmit a first refresh mode register read command REFMRR1 (for example, a refresh command including a read request for a MR4 mode register storing temperature information) to the memory device 1100 in a second period T2 (for example, 16 ms). For example, the memory controller 1200 may consecutively transmit the first refresh mode register read command REFMRR1 to the memory device 1100 at the second period T2. A time interval between two adjacent first refresh mode register read commands REFMRR1 may be the second period T2. The refresh command REFCMD and the first refresh mode register read command REFMRR1 may have a time interval of the first period T1. For example, a time interval between the refresh command REFCMD and the first refresh mode register read command REFMRR1 may be the first period T1.

The memory controller 1200 may transmit the third refresh mode register read command REFMRR3 and/or the fourth refresh mode register read command REFMRR4 to the memory device 1100. The refresh command REFCMD and the third refresh mode register read command REFMRR3 may have a time interval of the first period T1. The refresh command REFCMD and the fourth refresh mode register read command REFMRR4 may have a time interval of the first period T1. In an embodiment, the memory controller 1200 may transmit the refresh command REFCMD, the first refresh mode register read command REFMRR1, the third refresh mode register read command REFMRR3, and the fourth refresh mode register read command REFMRR4 such that a refresh operation is consecutively performed on the memory device 1100 at the first period T1.

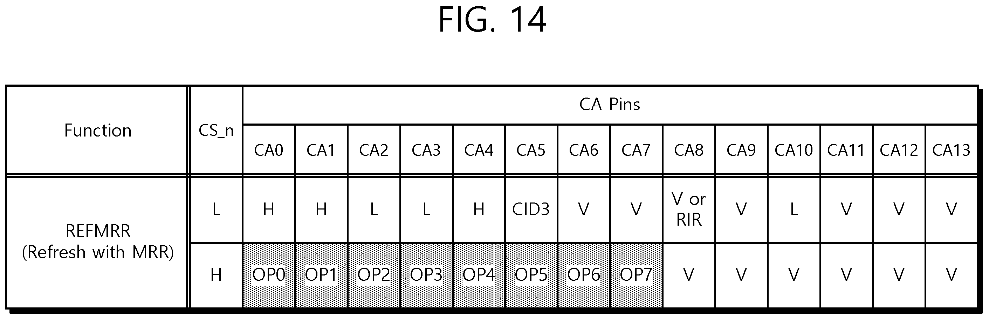

FIG. 14 is a table illustrating another example embodiment of a refresh command for performing the refresh operation and a mode register read operation in a combined manner on the memory device 1100 of FIG. 5. Referring to FIG. 14, a refresh mode register read command REFMRR is a refresh command for combined execution of a refresh operation and a mode register read operation.

The refresh mode register read command REFMRR may include a structure having two cycles according to a logic level of a signal applied to a chip select pin CS_n. For example, the refresh mode register read command REFMRR may be implemented for one command set having the two cycles. The first cycle of the refresh mode register read command REFMRR may correspond to a time interval during which a low level of the signal is provided to the chip select pin CS_n and may have a structure similar to the second refresh command REFCMD2 of FIG. 7. Accordingly, based on the first cycle of the refresh mode register read command REFMRR, the memory device 1100 may perform refresh operations for all memory banks.

The second cycle of the refresh mode register read command REFMRR may correspond to a time interval during which a high level of the signal is provided to the chip select pin CS_n and may provide an operation (OP) code for pointing location information (or an address) of a mode register through a specified column address pin (for example, CA0 to CA7). For example, 256 mode registers may be pointed one-to-one by a combination of eight operation (OP) codes (for example, OP0 to OP7). The value of the operation (OP) codes in the second cycle of the refresh mode register read command REFMRR may indicate (e.g. point to) an address of a corresponding mode register. Using the refresh mode register read command REFMRR of FIG. 14, the third refresh mode register read command REFMRR3 and/or the fourth refresh mode register read command REFMRR4 of FIG. 13 which are aperiodic may also be defined.

According to the present disclosure, it may be possible to output data stored in a mode register without performance degradation of the memory device 1100.

Embodiments are set out in the following Clauses:
Clause 1. A memory system comprising:
   a memory controller configured to consecutively issue a refresh command at a first period and a refresh mode register read command at a second period longer than the first period; and
   a memory device, connected to the memory controller, comprising:
      a memory cell array including a plurality of memory cells;
      an input/output circuit configured to transmit user data stored in the memory cell array to the memory controller;
      a mode register configured to store mode register information data related to the memory device and output the mode register information data through the input/output circuit according to a request of the memory controller; and
      a control logic circuit configured to:
         perform a refresh operation of the memory cell array based on the refresh command; and
         control the mode register to output the mode register information data in response to the refresh mode register read command while performing the refresh operation in response to the refresh mode register read command.
Clause 2. The memory device of Clause 1,
   wherein the memory controller is configured further to:
   schedule a mode register read command in the second period; and
   generate the refresh mode register read command by combining the mode register read command with the refresh command which is close to the mode register read command.
Clause 3. The memory device of Clause 1 or Clause 2,
   wherein the memory controller is configured further to provide position information of the mode register through a specified column address pin to perform the refresh mode register read command.
Clause 4. The memory device of any preceding Clause,
   wherein the refresh mode register read command includes a plurality of cycles, and
   wherein a portion of the plurality of cycles include a plurality of OP codes to point location information of the mode register.
Clause 5. The memory device of any preceding Clause,
   wherein the control logic circuit is configured to receive a first refresh mode register read command from the memory controller in the second period and receive a second refresh mode register read command in a third period which is longer than the second period.
Clause 6. The memory device of Clause 5,
   wherein the memory controller is configured further to set a time interval between the first refresh mode register read command and the refresh command to the first period.
Clause 7. The memory device of Clause 5 or Clause 6,
   wherein the memory controller is configured further to set a time interval between the second refresh mode register read command and the refresh command to the first period.
Clause 8. The memory device of any of Clauses 5-7,
   wherein the control logic circuit is configured further to receive a third refresh mode register read command which is aperiodic from the memory controller, and
   wherein the memory controller is configured further to set a time interval between the third refresh mode register read command and the refresh command to the first period.
Clause 9. A method of operating a memory device, the method comprising:
   periodically receiving a refresh command from a memory controller;
   performing a refresh operation during a refresh execution time based on the refresh command;
   checking whether the refresh command includes a mode register read request; and
   outputting, in response to the mode register read request being included in the refresh command, information data stored in the mode register corresponding to the mode register read request during the refresh execution time.
Clause 10. The method of Clause 9,
   wherein the refresh command is one of a normal refresh command consecutively issued at a first period by the memory controller and a refresh mode register read command consecutively issued, by the memory controller, at a second period greater than the first period.
Clause 11. The method of Clause 10,
   wherein the performing of the refresh operation and the outputting of the information data stored in the mode register are performed simultaneously in response to the refresh command being the refresh mode register read command.
Clause 12. The method of Clause 10 or Clause 11,
   wherein the outputting of the information data stored in the mode register includes receiving location information of the mode register through a specified column address pin of the memory device from the memory controller.
Clause 13. The method of any of Clauses 10-12,
   wherein the refresh command includes a plurality of cycles, and
   wherein the checking whether the refresh command includes the mode register read request includes obtaining location information of the mode register using a plurality of OP codes included in a portion of the plurality of cycles.
Clause 14. The method of any of Clauses 10-13, further comprising:
   generating the refresh mode register read command by combining a mode register read command scheduled to be consecutively issued at the second period by the memory controller with one of two adjacent normal refresh commands,
   wherein a scheduled time point of issuing the mode register read command by the memory controller is between scheduled time points of issuing the two adjacent normal refresh commands, and
   wherein the scheduled time point of the issuing the mode register read command is closer to a scheduled time point of the issuing the one of the two adjacent normal refresh commands.
Clause 15. The method of Clause 14, further comprising:
   scheduling, by the memory controller, a first mode register read command to be consecutively issued at the second period and a second mode register read command to be consecutively issued at a third period between a first normal refresh command and a second normal refresh command,
   wherein the generating of the refresh mode register read command include generating a first refresh mode register read command consecutively issued at the second period and a second refresh mode register read command consecutively issued at the third period greater than the second period,
   wherein the generating of the first refresh mode register read command includes combining the first mode register read command and the first normal refresh command which are close to each other to form the first refresh mode register read command, and
   wherein the generating of the second refresh mode register read command includes combining the second mode register read command and the second normal refresh command which are close to each other to form the second refresh mode register read command.

While the present disclosure has been described with reference to embodiments thereof, it will be apparent to those of ordinary skill in the art that various changes and modifications may be made thereto without departing from the scope of the present disclosure as set forth in the following claims.

## Claims

1. A memory device (1100) comprising:
a memory cell array (1110) including a plurality of memory cells;
a control logic circuit (1150) configured to perform a refresh operation of the memory cell array based on a refresh command (REFCMD) received from a memory controller (1200);
an input/output circuit (1160) configured to transmit user data stored in the memory cell array to the memory controller; and
a mode register (100) configured to store mode register information data (MRID) related to the memory device and output the mode register information data through the input/output circuit under control of the control logic circuit,
wherein the control logic circuit is configured further to perform, in response to a refresh mode register read command (REFMRR) received from the memory controller, the refresh operation of the memory cell array and an operation of controlling the mode register to output the mode register information data during a refresh execution time of the refresh operation.

2. The memory device of claim 1,
wherein the control logic circuit is configured further to:
perform the refresh operation in response to the refresh command consecutively received at a first period; and
control the mode register to output the mode register information data simultaneously with the refresh operation in response to the refresh mode register read command consecutively received at a second period which is longer than the first period.

3. The memory device of claim 2,
wherein the control logic circuit is configured further to receive the refresh command at a time interval of the first period after receiving the refresh mode register read command.

4. The memory device of any preceding claim,
wherein the refresh mode register read command includes address information of the mode register to be periodically read out through a column address pin.

5. The memory device of any preceding claim,
wherein the control logic circuit is configured further to:
receive from the memory controller a refresh mode register read command including a first cycle and a second cycle;
perform the refresh operation based on the first cycle; and
obtain a location information of the mode register using a plurality of operation codes included in the second cycle.

6. A memory system (1000) comprising:
the memory device of any preceding claim; and
the memory controller (1200), wherein the memory controller is connected to the memory device and configured to consecutively issue the refresh command (REFCMD) at a first period and the refresh mode register read command (REFMRR) at a second period longer than the first period.

7. The memory system of claim 6,
wherein the memory controller is configured further to:
schedule a mode register read command in the second period; and
generate the refresh mode register read command by combining the mode register read command with the refresh command which is closest to the mode register read command.

8. The memory system of claim 6 or claim 7,
wherein the memory controller is configured further to provide position information of the mode register through a specified column address pin to perform the refresh mode register read command.

9. The memory system of any of claims 6-8,
wherein the refresh mode register read command includes a plurality of cycles, and
wherein a portion of the plurality of cycles include a plurality of operation codes to point location information of the mode register.

10. The memory system of any of claims 6-9,
wherein the control logic circuit is configured to receive a first refresh mode register read command from the memory controller in the second period and receive a second refresh mode register read command in a third period which is longer than the second period.

11. The memory system of claim 10,
wherein the memory controller is configured further to set a time interval between the first refresh mode register read command and the refresh command to the first period.

12. The memory system of claim 10 or claim 11,
wherein the memory controller is configured further to set a time interval between the second refresh mode register read command and the refresh command to the first period.

13. The memory system of any of claims 10-12,
wherein the control logic circuit is configured further to receive a third refresh mode register read command which is aperiodic from the memory controller, and
wherein the memory controller is configured further to set a time interval between the third refresh mode register read command and the refresh command to the first period.

14. A method of operating a memory device (1100), the method comprising:
periodically receiving a refresh command (REFCMD) from a memory controller (1200);
performing a refresh operation during a refresh execution time based on the refresh command;
checking whether the refresh command includes a mode register read request; and
outputting, in response to the mode register read request being included in the refresh command, information data stored in the mode register corresponding to the mode register read request during the refresh execution time.

15. The method of claim 14,
wherein the refresh command is one of a normal refresh command consecutively issued at a first period by the memory controller and a refresh mode register read command (REFMRR) consecutively issued, by the memory controller, at a second period greater than the first period.
